# FASCICULE DE BREVET EUROPEEN

(11) **EP 4 360 413 B1**
(45) Date de publication et mention de la délivrance du brevet: **01.04.2026**
(21) Numéro de dépôt: 22737368.5
(22) Date de dépôt: 14.06.2022
(51) Int. Cl.: H05K 7/20

(54) **DISPOSITIF DE RÉGULATION THERMIQUE POUR SYSTÈME ÉLECTRONIQUE**
WÄRMEREGELUNGSVORRICHTUNG FÜR EIN ELEKTRONISCHES SYSTEM
THERMAL REGULATION DEVICE FOR ELECTRONIC SYSTEM

(30) Priorité: 22.06.2021 FR 2106644
(43) Date de publication de la demande: 01.05.2024
(73) Titulaire: Valeo Electrification, 95892 Cergy Pontoise (FR)
(72) Inventeur: JOVET, Bastien, 78320 Le Mesnil-Saint-Denis (FR); ROBILLON, Lionel, 78320 Le Mesnil-Saint-Denis (FR); TOURNEUX, Fabienne, 78320 Le Mesnil-Saint-Denis (FR); IBRAHIMI, Mohammed, 78320 Le Mesnil-Saint-Denis (FR); BATISTA, Juan Carlos, 78320 Le Mesnil-Saint-Denis (FR)
(74) Mandataire: Valeo Powertrain Systems
(86) Numéro de dépôt international: PCT/EP2022/066225
(87) Numéro de publication internationale: WO 2022/268587

(56) Documents cités:
- EP-A1- 3 291 357
- EP-A2- 2 337 143
- WO-A1-2017/033412
- WO-A1-2021/008541
- CN-A- 108 011 156
- CN-A- 109 524 583
- CN-A- 111 193 079
- CN-A- 111 653 709
- CN-A- 112 103 594
- CN-U- 206 834 293
- CN-U- 207 731 967
- CN-U- 210 245 575
- CN-U- 212 412 131
- JP-A- 2003 132 856
- JP-A- 2007 165 200
- JP-A- 2014 192 044
- KR-A- 20110 059 353
- KR-A- 20130 008 142
- KR-A- 20130 064 969
- KR-A- 20150 044 599
- KR-A- 20170 021 122
- US-A1- 2009 325 052
- US-A1- 2012 183 823
- US-A1- 2014 248 515
- US-A1- 2017 125 858
- US-A1- 2018 123 191
- US-A1- 2019 181 517
- US-A1- 2020 096 260

## Description

La présente invention se situe dans le domaine des dispositifs de régulation thermique de composants électriques ou électroniques, et elle concerne plus particulièrement un dispositif de régulation thermique d'un système électronique équipé de composants électriques et/ou électroniques susceptibles de s'échauffer lors de leur fonctionnement.

Les systèmes électroniques susceptibles d'être concernés par la présente invention peuvent aussi bien consister en des serveurs informatiques qu'en des systèmes de stockage d'énergie électrique pour des véhicules automobiles, et plus particulièrement pour des véhicules hybrides ou électriques.

Les motorisations électriques de tels véhicules font intervenir des systèmes électroniques pouvant prendre la forme de batteries, qui subissent des phases successives de charge et de décharge électriques et qui nécessitent d'être thermorégulées afin de protéger les composants qu'elles comprennent. Lorsque ces systèmes électroniques s'échauffent, par exemple lors d'une charge rapide, il est ainsi important de pouvoir les refroidir rapidement et efficacement, de façon à préserver leur efficacité.

Des dispositifs de régulation thermique peuvent ainsi être associés à ces batteries, pour modifier une température d'une batterie électrique, que ce soit lors d'un démarrage du véhicule par temps froid, en augmentant sa température par exemple, ou que ce soit en cours de roulage ou lors d'une opération de recharge de la batterie, en diminuant la température de cette batterie électrique, qui tend à s'échauffer au cours de son utilisation.

D'une manière générale, de tels dispositifs de régulation thermique de batteries électriques font appel à des échangeurs de chaleur. Les différentes cellules de batterie d'un système de stockage électrique peuvent notamment être refroidies au moyen d'une plaque froide à l'intérieur de laquelle circule un fluide de régulation thermique, la plaque étant en contact avec les cellules de batterie à refroidir. Il a pu être constaté que de tels échangeurs de chaleur peuvent conduire à un refroidissement non homogène des batteries électriques d'un même système de stockage électrique, entraînant alors une diminution de la performance globale du système de stockage électrique. Ces dispositifs de régulation thermique présentent en outre une résistance thermique élevée en raison des épaisseurs de matière présentes entre le fluide de régulation thermique et les cellules de batterie.

Dans le but d'apporter une réponse à ces différentes problématiques, on connaît des dispositifs de refroidissement des éléments de batterie électriques de voitures électriques ou hybrides comprenant un boîtier fermé hermétiquement dans lequel les éléments de batterie du système de stockage d'énergie électrique sont partiellement plongés dans un fluide de régulation thermique diélectrique. On assure de la sorte un échange thermique entre les éléments de batterie et le fluide diélectrique, une cuve de fluide diélectrique étant située à l'extérieur du boîtier et reliée audit boîtier par l'intermédiaire d'une pompe afin de permettre la circulation du fluide diélectrique et le renouvellement de ce fluide de régulation thermique diélectrique à l'intérieur du boîtier. De la sorte, le fluide de régulation thermique diélectrique, mis en mouvement et refroidi préalablement à son retour dans le boîtier, est également apte à circuler à l'intérieur du boîtier autour des cellules de stockage électrique. Cependant, il convient de noter que lorsque le fluide diélectrique refroidi est mis en mouvement par la pompe, les cellules de stockage disposées les plus loin de l'arrivée de fluide diélectrique dans le boîtier sont moins bien refroidies par échange de calories avec le fluide diélectrique que les cellules de stockage qui sont situées au plus proche de l'arrivée de fluide diélectrique, de sorte que le refroidissement des composants électriques ou électroniques n'est pas réalisé de façon homogène.

Afin de réaliser la mise en circulation du fluide de régulation thermique diélectrique, il est connu d'associer au boîtier des éléments d'alimentation et des éléments d'évacuation reliés fluidiquement à l'intérieur du boîtier et qui forment des saillies sur des parois du boîtier. Ces éléments d'alimentation et d'évacuation doivent ainsi être considérés dans l'encombrement de chaque dispositif de régulation thermique et ils sont notamment pénalisants en termes d'encombrement lorsqu'il est nécessaire de disposer plusieurs dispositifs de régulation thermique côte à côte, que ce soit pour des considérations de stockage lors d'un transport par exemple ou pour des considérations d'optimisation de la taille du système électronique lorsque ce système électronique nécessite la présence d'un grand nombre de composants électriques et/ou électroniques et donc de plusieurs dispositifs de régulation thermique.

Les documents US2017/125858 et CN212412131 connus de l'art antérieur décrivent de tels dispositifs.

La présente invention s'inscrit dans ce contexte en proposant un dispositif de régulation thermique pour système électronique comprenant un caisson configuré pour accueillir des composants électriques et/ou électroniques dudit système électronique, ce caisson présentant une paroi de fond et des parois latérales opposées deux à deux définissant un logement interne apte à recevoir les composants électriques et/ou électroniques, les faces externes de ces parois latérales étant définies comme celles étant opposées au logement interne, ce caisson comportant au moins un élément d'alimentation en fluide de régulation thermique, au moins un élément d'évacuation de fluide de régulation thermique, cet élément d'alimentation et cet élément d'évacuation étant communicants avec le logement interne, l'élément d'alimentation et l'élément d'évacuation faisant respectivement saillie sur l'une des faces externes des parois latérales du caisson, et en ce que l'élément d'alimentation et l'élément d'évacuation sont disposés sur les parois latérales à des distances différentes de la paroi de fond, caractérisé en ce que l'élément d'alimentation comporte un conduit s'étendant principalement le long d'une direction longitudinale, ce conduit étant délimité longitudinalement par deux parois parmi lesquelles une première paroi, au voisinage d'une première extrémité longitudinale du caisson, porte un embout, le conduit présentant une section, dans un plan perpendiculaire à la direction longitudinale, se réduisant au fur et à mesure de l'éloignement de la première paroi, et en ce que l'élément d'évacuation comporte un conduit s'étendant principalement le long d'une direction longitudinale, ce conduit étant délimité longitudinalement par deux parois parmi lesquelles une première paroi, au voisinage d'une deuxième extrémité longitudinale du caisson opposée à la première extrémité longitudinale du caisson, porte un embout, le conduit présentant une section, dans un plan perpendiculaire à la direction longitudinale, s'élargissant au fur et à mesure de l'éloignement de la première paroi.

Ce dispositif de régulation thermique est donc configuré de sorte que tous les composants électriques et/ou électroniques puissent être immergés, au moins partiellement, dans le fluide de régulation thermique. La présence du fluide de régulation thermique est assurée par l'intermédiaire d'au moins un élément d'alimentation, par lequel le fluide de régulation thermique pénètre dans le caisson et plus particulièrement dans le logement interne, et le renouvellement du fluide de régulation thermique au sein du logement interne, afin de pouvoir maintenir une température appropriée du fluide de régulation thermique d'au moins un élément d'évacuation de ce fluide. Ces éléments sont disposés sur les parois du caisson du dispositif de régulation thermique de telle sorte que la régulation thermique des composants électriques et/ou électroniques est optimisée, le fluide de régulation thermique pouvant s'écouler de façon uniforme entre chaque composant électrique et/ou électronique.

Par ailleurs, cette disposition des éléments d'alimentation et d'évacuation a pour effet de faciliter l'agencement de caissons adjacents. Le positionnement de ces éléments permettant d'imbriquer latéralement les dispositifs de régulation thermique les uns dans les autres, ces dispositifs peuvent en effet être disposés côte à côte avec un encombrement réduit.

La réduction de la section du conduit de l'élément d'alimentation permet notamment au fluide de régulation thermique qui y circule de se distribuer de façon uniforme au sein du logement interne dans lequel sont disposes les composants électriques et/ou électroniques. Cette réduction entraîne en effet une accélération du fluide de régulation thermique au fur et à mesure qu'il avance dans le conduit, assurant ainsi une propagation homogène d'une extrémité longitudinale à l'autre du dispositif de régulation thermique.

Selon un mode de réalisation de l'invention, l'élément d'alimentation fait saillie sur la face externe d'une paroi latérale du caisson et l'élément d'évacuation fait saillie sur la face externe d'une paroi latérale opposée du caisson.

Selon un mode de réalisation alternatif, l'élément d'alimentation et l'élément d'évacuation font saillie sur la face externe de la même paroi latérale du caisson.

Selon une caractéristique de l'invention, l'élément d'alimentation est séparé de la paroi de fond par une distance plus importante que la distance séparant l'élément d'évacuation de la paroi de fond.

Selon une caractéristique de l'invention, le conduit forme une saillie qui présente, dans un plan perpendiculaire à la direction longitudinale, une forme de U ouverte sur le logement interne du caisson.

Selon un mode de réalisation de l'invention, le caisson comporte une base et un couvercle, la base étant constituée par la paroi de fond et les parois latérales, cette base étant formée d'un seul tenant.

La base du caisson forme alors un ensemble monobloc de sorte qu'on ne peut pas séparer la paroi de fond des parois latérales sans détériorer l'une ou l'autre. Cet ensemble monobloc peut notamment être obtenu par fabrication additive, par exemple par impression 3D. Une seule opération de fabrication étant nécessaire, ce mode de réalisation offre des facilités de fabrication ainsi qu'un gain de temps et des coûts réduits.

Selon un mode de réalisation alternatif de l'invention, le caisson comporte une base et un couvercle, la base étant constituée par la paroi de fond et les parois latérales, cette base étant formée d'un premier élément comportant la paroi de fond et deux parois latérales opposées, les deux autres parois latérales étant rapportées et fixées sur le premier élément.

Plus particulièrement, le premier élément de la base peut être formé de la paroi de fond et des parois latérales opposées transversalement qui portent les éléments d'alimentation et d'évacuation, les deux autres parois latérales étant rapportées sur le premier élément pour fermer dans un deuxième temps le logement interne. Ce mode de réalisation nécessite plusieurs opérations de fabrication ; la base peut par exemple être formée par emboutissage, puis les autres parois latérales sont fixées par brasage sur cette base.

Selon une caractéristique de l'invention, le caisson est réalisé en un matériau choisi pour ses propriétés d'isolation thermique.

Particulièrement, ce matériau choisi pour ses propriétés d'isolation thermique peut être un matériau plastique.

Encore plus particulièrement, le matériau plastique peut être de **l'organosheet.**

Selon une caractéristique alternative de l'invention, au moins la paroi de fond et les parois portant l'élément d'alimentation et l'élément d'évacuation sont réalisées en métal.

Avantageusement, ce métal peut être de l'aluminium.

L'invention concerne également un système électronique comportant un dispositif de régulation thermique tel que précédemment évoqué et des composants électriques et/ou électroniques logés dans le caisson, et dans lequel les composants électriques et/ou électroniques sont séparés d'au moins un composant électrique et/ou électronique par un organe de séparation.

Cet organe de séparation joue le rôle d'entretoise, qui permet de distancer deux éléments. L'organe de séparation peut par exemple être une tôle ondulée, qui définit des canaux de passage de fluide le long de chacun des composants électriques et/ou électroniques disposés de part et d'autre de cet organe de séparation.

Selon une caractéristique de l'invention, l'organe de séparation est configuré pour laisser passer le fluide de régulation thermique entre deux composants électriques et/ou électroniques.

Par exemple, les composants électriques et/ou électroniques sont écartés d'une distance comprise entre 0,2 et 1 mm par l'organe de séparation.

Selon une autre caractéristique optionnelle de l'invention, le système électronique comprend un élément d'étanchéité configuré pour être agencé entre les composants électriques et/ou électroniques et les parois.

Selon une caractéristique de l'invention, l'élément d'étanchéité est disposé au voisinage de l'extrémité verticale des composants électriques et/ou électroniques opposée à la paroi de fond, cette extrémité verticale s'étendant dans une direction orthogonale à la paroi de fond.

Cette disposition particulière de l'élément d'étanchéité permet d'éviter l'immersion des éléments de connectique des composants électriques et/ou électroniques dans le fluide de régulation thermique, ces éléments de connectique étant disposés sur l'extrémité verticale des composants électriques et/ou électroniques.

D'autres caractéristiques, détails et avantages de l'invention ressortiront plus clairement à la lecture de la description qui suit d'une part, et d'exemples de réalisation donnés à titre indicatif et non limitatif en référence aux dessins annexés d'autre part, sur lesquels :
[Fig. 1] illustre, schématiquement, une vue en perspective d'un dispositif de régulation thermique d'un système électronique, ici des éléments de stockage d'énergie électrique représentés partiellement, selon l'invention ;
[Fig. 2] illustre, schématiquement, une vue en perspective d'une partie du dispositif de régulation thermique de la figure 1 ;
[Fig. 3] illustre, schématiquement, une vue en perspective du dispositif de régulation thermique selon une alternative de réalisation de l'invention ;
[Fig. 4] illustre, schématiquement, un agencement de deux dispositifs de régulation thermique conformes à l'invention, avec des conduits d'alimentation et d'évacuation de fluide de régulation thermique disposés sur des parois latérales opposées d'un même dispositif de régulation thermique ;
[Fig. 5] illustre, schématiquement, une vue de face d'une variante de l'agencement de la figure 4, avec deux dispositifs de régulation thermique conformes à l'invention qui présentent chacun des conduits d'alimentation et d'évacuation de fluide de régulation thermique disposés sur une même paroi latérale ;
[Fig. 6] illustre, schématiquement, une vue en perspective du dispositif de régulation thermique de la figure 3 ;
[Fig. 7] illustre, schématiquement, une représentation d'une alternative au dispositif de régulation thermique illustré sur la figure 6 ;
[Fig. 8] illustre, schématiquement, une vue en perspective d'un dispositif de régulation thermique conforme à l'invention, équipé ici d'un moyen d'étanchéité ;
[Fig. 9] illustre, schématiquement, le dispositif de régulation thermique de la figure 8, le caisson ayant été effacé pour faire apparaître les composants se trouvant à l'intérieur de celui-ci.

Sur les figures, les éléments communs à plusieurs figures conservent la même référence. Dans la description détaillée qui va suivre, les dénominations « longitudinale », « transversale » et « verticale » se réfèrent à l'orientation du dispositif de régulation thermique selon l'invention. Une direction longitudinale correspond à une direction principale d'allongement du caisson du dispositif de régulation thermique, cette direction longitudinale étant parallèle à un axe longitudinal L d'un repère L, V, T illustré sur les figures. Une direction transversale correspond à une direction dans laquelle les composants électriques et/ou électroniques s'étendent principalement, cette direction transversale étant parallèle à un axe transversal T du repère L, V, T et cet axe transversal T étant perpendiculaire à l'axe longitudinal L. Enfin, une direction verticale correspond à une direction parallèle à un axe vertical V du repère L, V, T, cet axe vertical V étant perpendiculaire à l'axe longitudinal L et à l'axe transversal T.

En outre, dans la présente description le terme « fluide de régulation thermique » peut se rapporter à tout fluide ou liquide caloporteur, diélectrique, diphasique ou réfrigérant, dès lors que ce fluide ou liquide a pour effet de refroidir les composants électriques et/ou électroniques d'un dispositif de régulation thermique.

Par ailleurs, dans la description détaillée qui va suivre, le dispositif de régulation thermique selon l'invention va être décrit en relation avec un système électronique sous forme d'un système de stockage d'énergie électrique de véhicule automobile, mais il doit être compris qu'une telle application n'est pas limitative et qu'elle pourrait notamment être appliquée dans le contexte de l'invention à des composants électriques ou électroniques équipant d'autres systèmes électroniques et par exemple des serveurs informatiques.

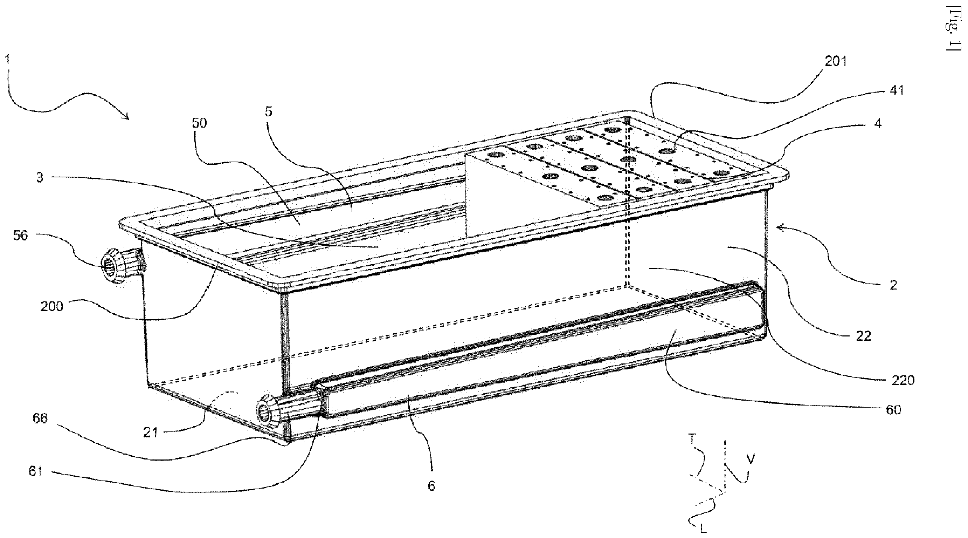

La figure 1 illustre ainsi, schématiquement, une vue en perspective d'un dispositif de régulation thermique 1 selon l'invention, configuré pour modifier la température, notamment en refroidissement, de composants électriques et/ou électroniques qui sont ici des cellules de module de batterie électrique pour véhicule hybride ou électrique. Ce dispositif de régulation thermique 1 comprend un caisson 2 allongé principalement selon une direction longitudinale, entre une première extrémité longitudinale 200 du caisson 2 et une deuxième extrémité longitudinale 201 du caisson 2. Le caisson 2 comporte une paroi de fond 21 et quatre parois latérales 22 opposées deux à deux, ces parois délimitant un logement interne 3, configuré pour accueillir les composants électriques et/ou électroniques 4. Une partie de ces composants électriques et/ou électroniques 4 a été retirée de l'illustration présentée en figure 1 afin de permettre une meilleure visualisation des autres composants du dispositif de régulation thermique 1.

Les composants électriques et/ou électroniques 4 sont disposés les uns à côté des autres le long de la direction longitudinale du caisson 2, en étant ici disposés parallèlement les uns aux autres, perpendiculairement à la direction longitudinale du caisson. Au moins l'une des faces d'un composant électrique et/ou électronique 4 s'étendant dans un plan vertical et transversal, perpendiculairement à la direction longitudinale du caisson, est en regard de l'une des faces, s'étendant dans un plan vertical et transversal, d'un composant électrique et/ou électronique 4 voisin. Chaque composant électrique et/ou électronique 4 est disposé à distance du composant électrique et/ou électronique 4 voisin, et à distance des parois latérales 22 qui délimitent le logement interne 3, de manière à définir entre chaque composant électrique et/ou électronique des espacements. Ces espacements permettent notamment au fluide de régulation thermique de circuler entre les composants électriques et/ou électroniques 4 et entre les composants électriques et/ou électroniques 4 et les parois latérales 22, ce qui assure une régulation thermique optimale de chacun des composants électriques et/ou électroniques au sein du dispositif de régulation thermique 1.

Les composants électriques et/ou électroniques 4 présentent, sur une face d'extrémité verticale 40 qui s'étend à l'opposé de la paroi de fond, des éléments de connectique 41 permettant de relier les composants électriques et/ou électroniques à un réseau électrique d'alimentation et/ou de distribution du véhicule.

Les parois latérales 22 du caisson 2 présentent des faces externes 220, ces faces externes 220 des parois latérales 22 étant définies comme celles qui sont opposées au logement interne 3.

Afin de permettre une circulation de fluide de régulation thermique au sein du dispositif de régulation thermique, et un renouvellement de ce fluide de régulation thermique pour faciliter l'échange, et notamment l'évacuation, de calories hors du caisson 2 du dispositif de régulation thermique 1, le caisson 2 comporte au moins un élément d'alimentation en fluide de régulation thermique 5 et au moins un élément d'évacuation de fluide de régulation thermique 6, ces éléments d'alimentation 5 et d'évacuation 6 étant communicants avec le logement interne 3. L'élément d'alimentation en fluide de régulation thermique 5 et l'élément d'évacuation de fluide de régulation thermique 6 font respectivement saillie sur l'une des faces externes 220 des parois latérales 22 du caisson 2.

Selon l'invention, cet élément d'alimentation 5 et cet élément d'évacuation 6 sont disposés sur les parois latérales 22 à des distances différentes de la paroi de fond 21. On comprend ainsi que l'élément d'alimentation en fluide de régulation thermique 5 peut être disposé sur une face externe 220 à une distance de la paroi de fond 21 plus importante que la distance séparant l'élément d'évacuation de fluide de régulation thermique 6 de cette paroi de fond 21, comme représenté sur la figure 1, ou inversement que l'élément d'évacuation de fluide de régulation thermique 6 peut être disposé sur une face externe 220 à une distance de la paroi de fond 21 plus importante que la distance séparant l'élément d'alimentation en fluide de régulation thermique 5 de cette paroi de fond 21.

L'élément d'alimentation en fluide de régulation thermique 5 et l'élément d'évacuation en fluide de régulation thermique 6 comportent chacun un conduit 50, 60 le long duquel le fluide de régulation thermique est apte à circuler pour pénétrer dans le caisson 2 ou pour en sortir.

Le conduit d'alimentation 50 de l'élément d'alimentation en fluide de régulation thermique 5 et le conduit d'évacuation 60 de l'élément d'évacuation de fluide de régulation thermique 6 forment respectivement une saillie en forme de U sur l'une des faces externes 220 des parois latérales 22, cette saillie étant ouverte sur le logement interne 3 du caisson 2. La saillie formée par ces conduits 50, 60 est dite en U en ce que, dans un plan de section perpendiculaire à la paroi latérale 22, le profil du conduit 50, 60 est ouvert sur le logement, une communication fluidique étant formée entre le conduit 50, 60 et le logement interne 3 via une ouverture formée dans la paroi latérale 22 correspondante, ladite ouverture s'étendant sur sensiblement toute la dimension longitudinale du conduit 50, 60.

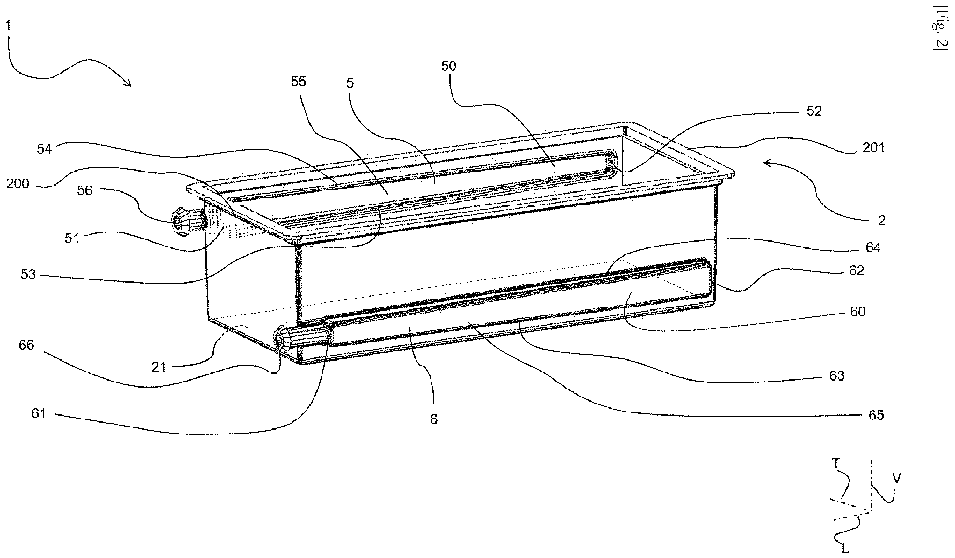

Comme illustré sur la figure 2, dans laquelle les composants électriques et/ou électroniques 4 ont été retirés du caisson 2, l'élément d'alimentation en fluide de régulation thermique 5 et l'élément d'évacuation de fluide de régulation thermique 6 sont respectivement formés des conduits 50, 60, qui sont réalisés ici par des déformations des parois latérales 22 pour former les saillies en U, et d'embouts 56, 66. Ces conduits 50, 60 sont configurés pour permettre une circulation longitudinale du fluide de régulation thermique et une distribution homogène pour chacun des composants électriques et/ou électroniques disposés dans le logement interne 3.

Les embouts 56 et 66 sont respectivement situés, selon le mode de réalisation représenté par la figure 2, sur des premières parois d'extrémité longitudinale 51, 61 de chacun des conduits, ces premières parois d'extrémité longitudinale étant au voisinage de la première extrémité longitudinale 200 du caisson 2. Ces premières parois d'extrémité longitudinale 51, 61 définissent une extrémité longitudinale des conduits 50, 60, l'autre extrémité longitudinale correspondant à des deuxièmes parois d'extrémité longitudinale 52, 62 situées au voisinage de la deuxième extrémité longitudinale 201 du caisson 2. Les premières parois d'extrémité longitudinale 51, 61 et les deuxièmes parois d'extrémité longitudinale 52 et 62 sont sensiblement parallèles entre elles, et sont sensiblement perpendiculaires aux parois latérales 22 qui supportent les éléments d'alimentation en fluide de régulation thermique 5 et d'évacuation de fluide de régulation thermique 6.

Par ailleurs, les conduits 50, 60 sont respectivement délimités verticalement par des parois inférieures 53, 63 et par des parois supérieures 54, 64, les parois inférieures 53, 63 étant définies comme celles qui présentent une distance à la paroi de fond 21 inférieure à la distance séparant les parois supérieures 54, 64 de cette paroi de fond 21.

Des parois transversales 55, 65, sensiblement parallèles aux parois latérales 22 qui portent l'élément d'alimentation en fluide de régulation thermique 5 et l'élément d'évacuation de fluide de régulation thermique 6, délimitent respectivement les conduits 50, 60 selon une direction transversale.

On comprend donc que le conduit d'alimentation 50 de l'élément d'alimentation en fluide de régulation thermique 5 est délimité longitudinalement par la première paroi d'extrémité longitudinale 51 et la deuxième paroi d'extrémité longitudinale 52, verticalement par la paroi inférieure 53 et la paroi supérieure 54, et transversalement par la paroi transversale 55. La même délimitation est applicable *mutatis mutandis* au conduit d'évacuation 60 de l'élément d'évacuation de fluide de régulation thermique 6.

Dans l'exemple illustré sur la figure 2, l'embout 56 du conduit d'alimentation 50 de l'élément d'alimentation en fluide de régulation thermique 5 étant disposé sur la première paroi d'extrémité longitudinale 51, il est donc au voisinage de la première extrémité longitudinale 200 du caisson 2. De la même façon, l'embout 66 du conduit d'évacuation 60 de l'élément d'évacuation de fluide de régulation thermique 6 est au voisinage de la première extrémité longitudinale 200 du caisson 2.

Le conduit d'alimentation 50 présente une section se réduisant au fur et à mesure de l'éloignement de la première paroi d'extrémité longitudinale 51, et donc au fur et à mesure de l'éloignement de la première extrémité longitudinale 200 du caisson 2. La réduction de section s'entend notamment ici par une diminution de la hauteur du conduit d'alimentation 50, cette hauteur étant définie comme la dimension verticale du conduit d'alimentation 50 qui est mesurée entre la paroi inférieure 53 et la paroi inférieure 54. Cette hauteur du conduit d'alimentation 50 est donc plus importante à proximité de la première paroi d'extrémité longitudinale **51** que de la deuxième paroi d'extrémité longitudinale 52.

À l'inverse, le conduit d'évacuation 60 présente une section s'élargissant au fur et à mesure de l'éloignement de la première paroi **61,** et donc au fur et à mesure de l'éloignement de la première extrémité longitudinale 200 du caisson 2. L'agrandissement de section s'entend notamment ici par une augmentation de la hauteur du conduit d'évacuation 60, cette hauteur étant définie comme la dimension du conduit d'évacuation 60 qui est mesurée entre la paroi inférieure 63 et la paroi inférieure 64. Cette hauteur du conduit d'évacuation 60 est donc plus importante à proximité de la première paroi d'extrémité longitudinale **61** que de la deuxième paroi d'extrémité longitudinale 62.

Les caractéristiques des conduits 50, 60 selon lesquelles ils présentent une section se réduisant ou une section s'élargissant depuis l'embout correspondant permettent de faire évoluer la section de passage disponible pour le fluide de régulation thermique au sein du conduit correspondant. De la sorte, la réduction de section de passage du conduit d'alimentation 50 permet de forcer le fluide de régulation thermique à accélérer et à circuler jusqu'à l'extrémité longitudinale opposée à l'embout d'entrée de ce conduit d'alimentation 50, ce qui permet de s'assurer que le fluide de régulation thermique circule jusqu'au bout du conduit d'alimentation et est distribué de façon homogène au sein du logement interne 3, et donc entre les composants électriques et/ou électroniques 4 et autour de ceux-ci. De même, l'augmentation de section de passage du conduit d'évacuation 50 permet de faire pénétrer dans le conduit d'évacuation 50 plus de fluide de régulation thermique dans une zone à distance de l'embout 56 par lequel le fluide de régulation thermique quitte le caisson 2. On s'assure ainsi que le renouvellement du fluide de régulation thermique soit homogène sur toute la dimension longitudinale du caisson 2.

Une distribution homogène du fluide de régulation thermique entre les composants électriques et/ou électroniques 4 au sein du logement interne 3 est également assurée par le fait que lorsque le conduit d'alimentation en fluide de régulation thermique 50 présente une section se réduisant au fur et à mesure de l'éloignement de la première extrémité longitudinale 200 du caisson 2 et que le conduit d'évacuation de fluide de régulation thermique 60 présente une section s'élargissant au fur et à mesure de l'éloignement de cette première extrémité longitudinale 200, la section où la hauteur du conduit d'alimentation 50 est maximale est placée en regard, à travers le logement interne 3, de la section où la hauteur du conduit d'évacuation 60 est minimale, lorsque ces hauteurs sont mesurées à la même distance longitudinale de la première extrémité longitudinale 200 ou de la deuxième extrémité longitudinale 201. Inversement, la section où la hauteur du conduit d'alimentation 50 est minimale est placée en regard, à travers le logement interne 3, de la section où la hauteur du conduit d'évacuation 60 est maximale. Le conduit d'alimentation 50 et le conduit d'évacuation 60 présentent donc des variations de leurs sections en opposition qui contribue à faciliter la circulation du fluide entre les composants électriques et/ou électroniques 4 d'un conduit à l'autre et de manière homogène sur toute la dimension longitudinale du caisson. Le fluide de régulation thermique est attiré par la zone du conduit d'évacuation 60 où la hauteur de la section est maximale, et pour arriver dans cette zone, il tend à circuler dans le conduit d'alimentation 50 jusqu'à une zone en regard et donc jusqu'à une zone du conduit d'alimentation 50 où la hauteur de la section est minimale, ce qui participe à pousser le fluide jusqu'au bout du conduit d'alimentation 50.

De manière alternative, on peut prévoir que le conduit d'évacuation 60 de l'élément d'évacuation de fluide de régulation thermique 6 soit équipé d'un embout 66 qui est disposé au voisinage de la deuxième extrémité longitudinale 201 du caisson 2. Dans cette alternative, il convient de noter que la forme du conduit d'évacuation resterait la même pour que la section de plus grand diamètre soit disposée près de cette deuxième extrémité longitudinale 201, et que dès lors, la section du conduit d'évacuation se réduirait au fur et à mesure de l'éloignement de l'embout.

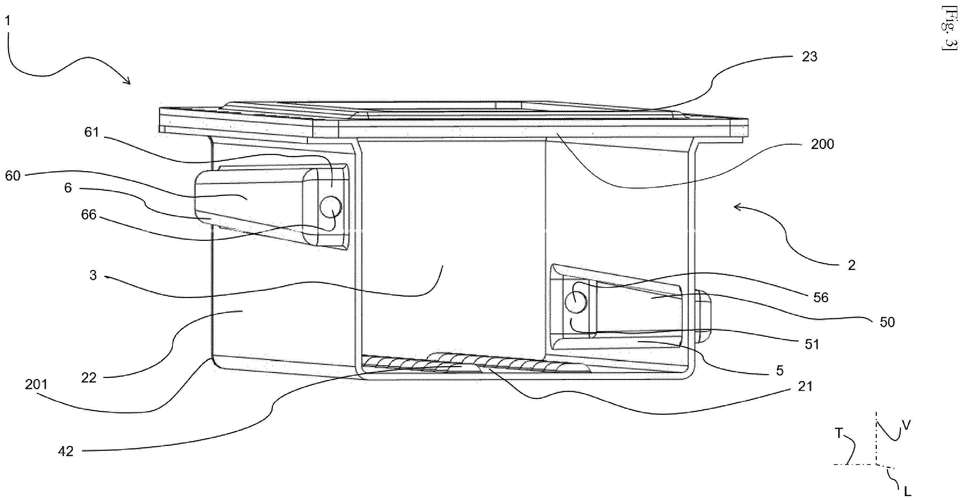

Une telle alternative est notamment illustrée sur la figure 3, dans laquelle la paroi latérale 22 située à la première extrémité longitudinale 200 du caisson 2 a été retirée, et dans laquelle le logement interne 3 est vide de tout composant électrique et/ou électronique 4, afin de rendre visible l'intérieur du caisson 2 et la communication fluidique entre le logement interne 3 et l'un des conduits, ici le conduit d'évacuation 60.

Le caisson 2 comporte un couvercle 23, qui vient fermer le logement interne 3 défini par les parois latérales 22. Ce couvercle 23 repose sur un rebord formé par une extrémité verticale de ces parois latérales 22 à l'opposé de la paroi de fond, ce rebord s'étendant vers l'extérieur du logement interne 3. Le couvercle 23 s'étend de la première extrémité longitudinale 200 du caisson 2 à la deuxième extrémité longitudinale 201 du caisson 2, sensiblement parallèlement à la paroi de fond 21.

Au moins l'une des parois, ici la paroi de fond 21, comporte des éléments de maintien 42 qui sont configurés pour maintenir les composants électriques et/ou électroniques 4 les uns à distance des autres et à distance des parois délimitant le logement interne 3 du caisson 2. A titre d'exemple, les éléments de maintien visibles sur la figure 3 consistent en des nervures qui forment une surface d'appui des composants électriques et/ou électroniques 4 à distance de la paroi de fond 21, afin de permettre une circulation de fluide de régulation thermique entre la paroi de fond 21 et les composants électriques et/ou électroniques 4.

Dans chacun des modes de réalisation ou alternatives décrites en référence aux figures 1 à 3, l'élément d'évacuation de fluide de régulation thermique 6 est séparé de la paroi de fond 21 d'une distance moins importante que la distance séparant l'élément d'alimentation en fluide de régulation thermique 5 de cette paroi de fond 21. Il convient toutefois de noter que sans sortir du contexte de l'invention, il pourrait être prévu un agencement inverse, avec l'élément d'évacuation de fluide de régulation thermique 6 qui serait séparé de la paroi de fond 21 d'une distance plus importante que la distance séparant l'élément d'alimentation en fluide de régulation thermique 5 de cette paroi de fond 21, dès lors que la position d'un de ces conduits par rapport à la paroi de fond est différente de la positon de l'autre de ces conduits et qu'il est possible de disposer côte à côte deux caissons 2 similaires sans que les conduits 50,60 ne gênent leur rapprochement.

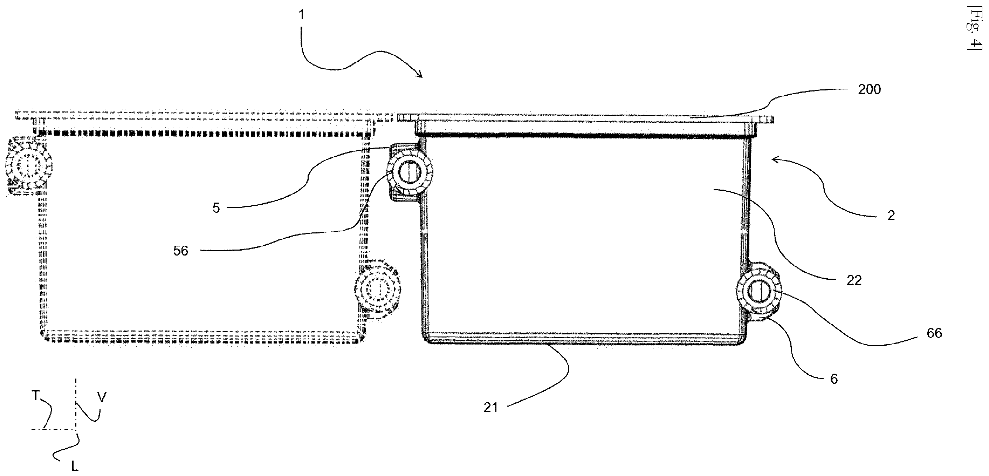

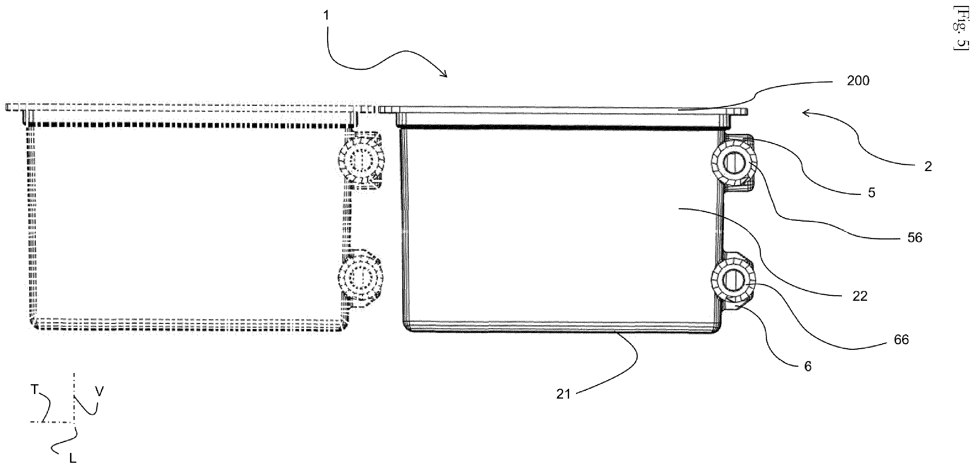

La figure 4 et la figure 5 représentent des vues de face de deux variantes de réalisation du dispositif de régulation thermique 1 selon l'invention, qui permettent cet avantage en termes d'encombrement, en ayant un des conduits, ici le conduit d'alimentation 5, qui est disposé plus loin de la paroi de fond que ne l'est le conduit d'évacuation 6.

### // Question aux inventeurs : quel est l'intérêt d'avoir l'élément d'alimentation dans la partie supérieure du boîtier, tel qu'illustré ? //

Dans la variante de réalisation illustrée par la figure 4, l'élément d'alimentation en fluide de régulation thermique 5 et l'élément d'évacuation de fluide de régulation thermique 6 font saillie sur deux parois latérales 22 du caisson 2 qui sont opposées transversalement l'une à l'autre.

À l'inverse, dans la variante de réalisation illustrée par la figure 5, l'élément d'alimentation en fluide de régulation thermique 5 et l'élément d'évacuation de fluide de régulation thermique 6 font saillie sur la même paroi latérale 22 du caisson 2.

Sur ces figures 4 et 5, l'embout 56 de l'élément d'alimentation en fluide de régulation thermique 5 et l'embout 66 de l'élément d'évacuation de fluide de régulation thermique 6 sont tous deux au voisinage de la même extrémité longitudinale du caisson 2. On pourrait également envisager des modes de réalisation dans lesquels l'embout 56 de l'élément d'alimentation en fluide de régulation thermique 5 serait au voisinage de l'une des extrémités longitudinales du caisson 2 tandis que l'embout 66 de l'élément d'évacuation de fluide de régulation thermique 6 serait au voisinage de l'autre extrémité longitudinale du caisson 2.

La disposition particulière des éléments d'alimentation en fluide de régulation thermique 5 et d'évacuation de fluide de régulation thermique 6 offre des facilités de rangement et d'imbrication d'un dispositif de régulation thermique selon l'invention avec les dispositifs de régulation thermique de forme équivalente qui lui seraient adjacents, tel que représenté en pointillés sur les figures 4 et 5.

Dans la variante illustrée sur la figure 4, ces dispositifs de régulation thermique peuvent être disposés au plus proche avec le rebord de fixation du couvercle de ces dispositifs de régulation thermique qui se touchent, puisque la paroi latérale d'un premier dispositif sur laquelle est formé l'élément d'alimentation 5 est disposée en regard de la paroi latérale du deuxième dispositif de régulation thermique sur laquelle est formé l'élément d'évacuation 6. La différence de positionnement vertical de chaque type de conduit permet ainsi de glisser l'un au-dessus de l'autre l'élément d'évacuation d'un dispositif de régulation thermique et l'élément d'alimentation d'un dispositif de régulation thermique voisin.

Dans la variante illustrée sur la figure 5, ces dispositifs de régulation thermique peuvent être disposés au plus proche l'un de l'autre, avec le rebord de fixation du couvercle de ces dispositifs de régulation thermique qui se touchent, puisque la paroi latérale d'un premier dispositif sur laquelle sont formés l'un au-dessus de l'autre l'élément d'alimentation 5 et l'élément d'évacuation 6 est disposée en regard de la paroi latérale du deuxième dispositif de régulation thermique qui est dépourvue de conduits.

Le fait que le conduit d'alimentation en fluide de régulation thermique 5 présente une réduction de section depuis la première extrémité longitudinale et que le conduit d'évacuation de fluide de régulation thermique 6 présente un agrandissement de section depuis la même extrémité longitudinale permet de positionner, dans la zone formée entre les deux dispositifs de régulation thermique voisins, la portion du conduit d'alimentation en fluide de régulation thermique 5 qui a une hauteur telle que définie précédemment maximale est donc disposé à l'aplomb de la portion du conduit d'évacuation de fluide de régulation thermique 6 qui a une hauteur telle que définie précédemment minimale. Un tel agencement permet notamment d'éviter que l'embout 56 du premier dispositif de régulation thermique 1 soit au contact de l'embout 66 du deuxième dispositif de régulation thermique 1, bien qu'ils soient disposés au voisinage de la même extrémité longitudinale du caisson 2.

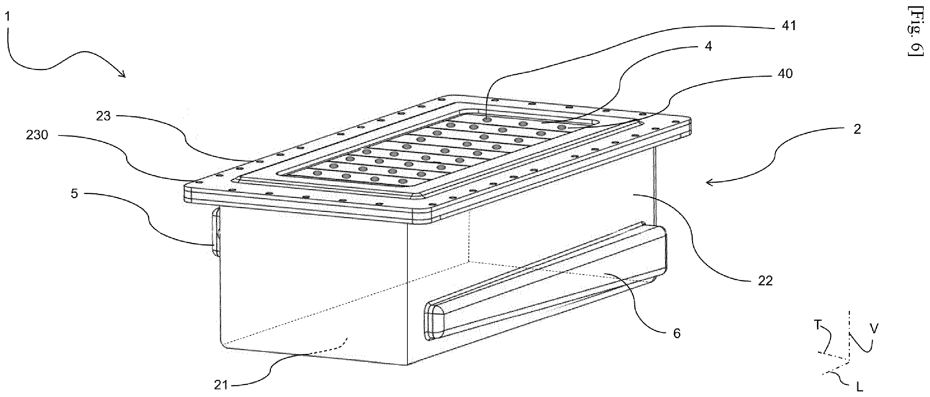

La figure 6 illustre le dispositif de régulation thermique 1 dans son ensemble, avec un agencement des embouts des conduits similaires à celui de la figure 3. Tel que cela est visible, le caisson 2 comporte une base, constituée de la paroi de fond 21 et des parois latérales 22, et le couvercle 23 précédemment évoqué, la base étant dimensionnée pour être recouverte par le couvercle.

Cette base forme un ensemble monobloc, qui est formé d'un seul tenant. Il n'est donc pas possible de séparer la paroi de fond 21 des parois latérales 22 sans détériorer l'un ou l'autre de ces éléments. L'ensemble monobloc peut notamment être obtenu par injection de matière plastique, ou bien par fabrication additive, et plus particulièrement par impression 3D. Dans ce contexte, le caisson 2 peut être réalisé en un matériau choisi pour ses propriétés d'isolation thermique. Particulièrement, ce matériau choisi pour ses propriétés d'isolation thermique peut être un matériau plastique. Encore plus particulièrement, ce matériau plastique peut être de l'organosheet.

Le couvercle 23 constitue un cadre vide en son centre qui ne recouvre que les parties des composants électriques et/ou électroniques 4 qui sont au voisinage des parois latérales 22, laissant ainsi accessibles les éléments de connectique 41 des composants électriques et/ou électroniques 4 qui sont disposés sur la face d'extrémité verticale 40 de ces composants électriques et/ou électroniques 4. Ce couvercle 23 peut être fixé à la base du caisson 2 par l'intermédiaire de vis ou de rivets 230, garantissant ainsi l'étanchéité du dispositif de régulation thermique 1.

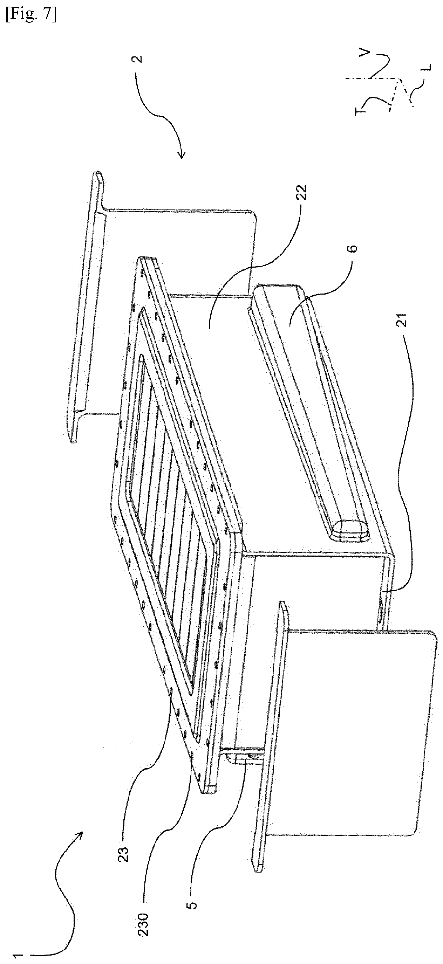

La figure 7 présente un mode de réalisation alternatif du dispositif de régulation thermique de la figure 6, dans lequel la base du caisson 2 est ici formée d'un premier élément comportant la paroi de fond 21 et deux parois latérales opposées 22, tandis que les deux autres parois latérales 22 sont réalisées de manière indépendante puis rapportées sur le premier élément. Dans l'exemple illustré, la base est constituée de la paroi de fond 21 et des parois latérales 22 opposées qui portent l'élément d'alimentation en fluide de régulation thermique 5 et l'élément d'évacuation de fluide de régulation thermique 6, les deux autres parois latérales 22 étant rapportées sur le premier élément de la base 24.

Au moins la paroi de fond 21 et les parois latérales 22 portant l'élément d'alimentation en fluide de régulation thermique 5 et l'élément d'évacuation de fluide de régulation thermique 6 peuvent être réalisées en métal. Avantageusement, ce métal peut être de l'aluminium.

Dans ce contexte, le premier élément de la base 24 peut par exemple être formé par emboutissage, ce qui simplifie la formation de la section en U de chacun des conduits, puis les autres parois latérales sont fixées par brasage sur cette base.

Comme pour le mode de réalisation présenté dans la figure 6, le couvercle 23 constitue un cadre vide en son centre qui ne recouvre que les parties des composants électriques et/ou électroniques 4 qui sont au voisinage des parois latérales 22, laissant ainsi accessibles les éléments de connectique 41 des composants électriques et/ou électroniques 4 qui sont disposés sur l'extrémité verticale de ces composants électriques et/ou électroniques 4. Ce couvercle 23 peut être fixé à la base du caisson 2 par l'intermédiaire de vis ou de rivets 230.

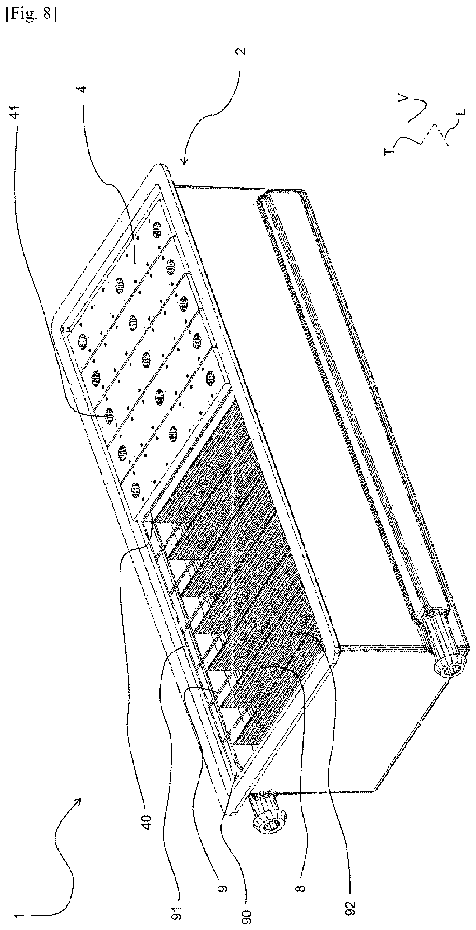

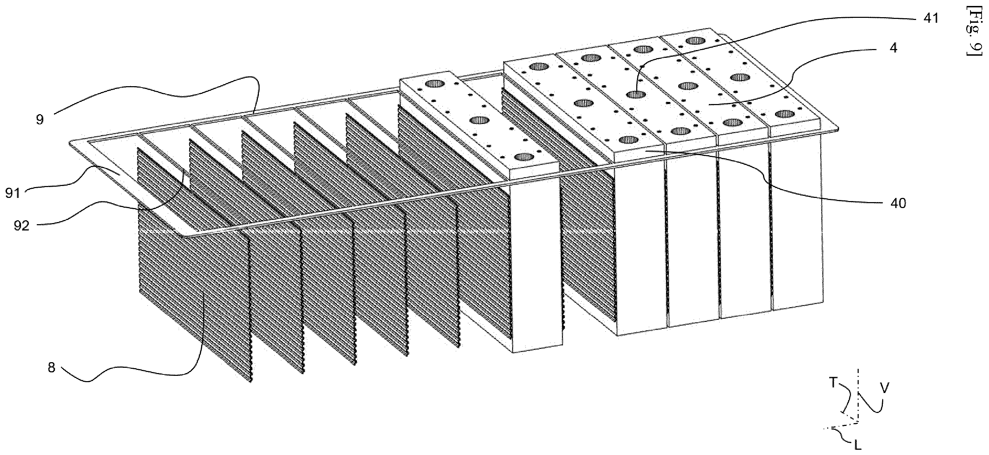

On va maintenant décrire, en référence aux figures 8 et 9, une caractéristique additionnelle du dispositif de régulation thermique 1 qui peut être mise en œuvre aussi bien dans le mode de réalisation de la figure 6 que dans celui de la figure 7, le caisson 2 ayant été effacé sur la figure 9 pour faire apparaître les composants se trouvant à l'intérieur de celui-ci.

Les composants électriques et/ou électroniques 4 sont ici séparés d'au moins un composant électrique et/ou électronique voisin par un organe de séparation 8. Chaque organe de séparation 8 s'étend donc au sein du logement interne d'une extrémité à l'autre du caisson 2 selon une direction sensiblement transversale.

L'organe de séparation 8 constitue une entretoise, qui permet d'assurer une distance définie entre deux composants électriques et/ou électroniques 4 adjacents. Cet organe de séparation 8 peut s'intercaler entre chaque composant électrique et/ou électronique 4, ou encore être placé tous les deux composants électriques et/ou électroniques 4, de façon que chaque composant électrique et/ou électronique 4 soit séparé d'au moins un autre composant électrique et/ou électronique 4 par un organe de séparation 8.

L'organe de séparation 8 peut notamment être une tôle ondulée, qui définit des canaux de passage de fluide de régulation thermique le long de chacun des composants électriques et/ou électroniques 4 disposés de part et d'autre de cet organe de séparation 8. On comprend ainsi que l'organe de séparation 8 est configuré pour laisser passer le fluide de régulation thermique. Les ondulations de la tôle de l'organe de séparation sont agencées de manière à autoriser et guider transversalement la circulation du fluide de régulation thermique, d'une paroi latérale à l'autre.

Selon un mode de réalisation préférentiel de l'invention, les composants électriques et/ou électroniques 4 sont écartés d'une distance comprise entre 0,2 et 1 mm par l'organe de séparation 8.

Le dispositif de régulation thermique 1 peut également comprendre un élément d'étanchéité 9, par exemple un joint, configuré pour être agencé entre les composants électriques et/ou électroniques et les parois. Cet élément d'étanchéité 9 présente un pourtour 91 qui repose sur un épaulement 90 formé sur les parois latérales 22 à l'intérieur du logement interne 3, ce pourtour 91 épousant donc la forme périphérique du logement interne 3. L'élément d'étanchéité 9, par exemple un joint, présente également des nervures transversales 92, qui s'étendent en travers du pourtour 91, d'une extrémité transversale à l'autre de l'élément d'étanchéité 9.

Cet élément d'étanchéité 9 est disposé au voisinage de la face d'extrémité verticale 40 des composants électriques et/ou électroniques 4 opposée à la paroi de fond 21. On comprend que la position de l'élément d'étanchéité est fonction de la hauteur d'immersion souhaitée pour réguler la température des composants électriques et/ou électroniques. Le pourtour 91, collé contre les parois latérales et disposés entre ces parois latérales et les composants électriques et/ou électroniques, empêche le fluide de régulation thermique de s'échapper du logement interne et il doit au moins être disposé verticalement entre le conduit 50, 60 disposé le plus loin de la paroi de fond et la face d'extrémité 40 des composants électriques et/ou électroniques.

Les nervures transversales 92 sont configurées de façon à pouvoir s'intercaler entre chaque composant électrique et/ou électronique 4, assurant ainsi l'étanchéité de l'extrémité verticale 40 de chaque composant électrique et/ou électronique 4.

Cette disposition particulière de l'élément d'étanchéité 9 permet d'éviter que le fluide de régulation thermique ne sorte du logement interne 3, une telle fuite étant préjudiciable à la fois pour le risque que peut présenter le contact des éléments de connectique 41 des composants électriques et/ou électroniques 4 avec le fluide de régulation thermique, et pour la baisse du niveau de fluide de régulation thermique au sein du logement interne 3 et la perte d'efficacité de régulation thermique qui en découlerait.

La présente invention propose ainsi un dispositif de régulation thermique pour système électronique dans lequel les composants électriques et/ou électroniques sont disposés de façon à être au moins partiellement immergés dans le fluide de régulation thermique, ce dispositif étant configuré pour d'une part permettre une circulation du fluide de régulation thermique optimisée et donc une thermorégulation améliorée, et pour d'autre part permettre un positionnement côte à côte compact de plusieurs dispositifs de régulation thermique selon l'invention, que ce soit pour des questions d'encombrement lors d'opération de transport ou de mise en œuvre de système électronique important nécessitant un grand nombre de composants électriques et/ou électroniques.

## Revendications

1. Dispositif de régulation thermique (1) pour système électronique comprenant un caisson (2) configuré pour accueillir des composants électriques et/ou électroniques (4) dudit système électronique, ce caisson (2) présentant une paroi de fond (21) et des parois latérales (22) opposées deux à deux définissant un logement interne (3) apte à recevoir les composants électriques et/ou électroniques (4), des faces externes (220) de ces parois latérales (22) étant définies comme celles étant opposées au logement interne (3), ce caisson (2) comportant :
- au moins un élément d'alimentation en fluide de régulation thermique (5) ;
- au moins un élément d'évacuation de fluide de régulation thermique (6) cet élément d'alimentation (5) et cet élément d'évacuation (6) étant communicants avec le logement interne (3), l'élément d'alimentation (5) et l'élément d'évacuation (6) faisant respectivement saillie sur l'une des faces externes (220) des parois latérales (22) du caisson (2), **et** en ce que l'élément d'alimentation (5) et l'élément d'évacuation (6) sont disposés sur les parois latérales (22) à des distances différentes de la paroi de fond (21), **caractérisé en ce que** l'élément d'alimentation (5) comporte un conduit (50) s'étendant principalement le long d'une direction longitudinale, ce conduit (50) étant délimité longitudinalement par deux parois (51, 52) parmi lesquelles une première paroi (51), au voisinage d'une première extrémité longitudinale du caisson (200), porte un embout (56), le conduit (50) présentant une section, dans un plan perpendiculaire à la direction longitudinale, se réduisant au fur et à mesure de l'éloignement de la première paroi (51), et **en ce que** l'élément d'évacuation (6) comporte un conduit (60) s'étendant principalement le long d'une direction longitudinale, ce conduit (60) étant délimité longitudinalement par deux parois (61, 62) parmi lesquelles une première paroi (61), au voisinage d'une deuxième extrémité longitudinale du caisson (201) opposée à la première extrémité longitudinale du caisson (200), porte un embout (66), le conduit (60) présentant une section, dans un plan perpendiculaire à la direction longitudinale, s'élargissant au fur et à mesure de l'éloignement de la première paroi (61).

2. Dispositif de régulation thermique (1) selon la revendication précédente, dans lequel l'élément d'alimentation (5) fait saillie sur la face externe (220) d'une paroi latérale (22) du caisson (2) et l'élément d'évacuation (6) fait saillie sur la face externe (220) d'une paroi latérale (22) opposée du caisson (2).

3. Dispositif de régulation thermique (1) selon l'une quelconque des revendications précédentes, dans lequel l'élément d'alimentation (5) est séparé de la paroi de fond (22) par une distance plus importante que la distance séparant l'élément d'évacuation (6) de la paroi de fond (22).

4. Dispositif de régulation thermique (1) selon l'une quelconque des revendications précédentes, dans lequel le conduit (50, 60) forme une saillie qui présente, dans un plan perpendiculaire à la direction longitudinale, une forme de U ouverte sur le logement interne (3) du caisson (2).

5. Dispositif de régulation thermique (1) selon l'une quelconque des revendications 1 à **4,** dans lequel le caisson (2) comporte une base et un couvercle (23), la base étant constituée par la paroi de fond (21) et les parois latérales (22), cette base étant formée d'un premier élément comportant la paroi de fond (21) et deux parois latérales (22) opposées, les deux autres parois latérales (22) étant rapportées et fixées sur le premier élément.

6. Système électronique comportant un dispositif de régulation thermique (1) selon l'une quelconque des revendications précédentes et des composants électriques et/ou électroniques (4) logés dans le caisson (2) dudit dispositif de régulation thermique (1), dans lequel les composants électriques et/ou électroniques (4) sont séparés d'au moins un composant électrique et/ou électronique (4) par un organe de séparation (8).

7. Système électronique selon la revendication 6, comprenant un élément d'étanchéité (9) configuré pour être agencé entre les composants électriques et/ou électroniques (4) et les parois (22).

## Patentansprüche

1. Thermische Regulierungsvorrichtung (1) für ein elektronisches System, umfassend einen Kasten (2), der konfiguriert ist, um elektrische und/oder elektronische Komponenten (4) des elektronischen Systems aufzunehmen, wobei dieser Kasten (2) eine Bodenwand (21) und paarweise gegenüberliegende Seitenwände (22) aufweist, die einen internen Hohlraum (3) definieren, der geeignet ist, die elektrischen und/oder elektronischen Komponenten (4) aufzunehmen, wobei Außenflächen (220) dieser Seitenwände (22) als diejenigen definiert sind, die dem internen Hohlraum (3) gegenüberliegen, wobei dieser Kasten (2) umfasst:
- mindestens ein Zufuhrelement für thermisches Regulierungsfluid (5);
- mindestens ein Abfuhrelement für thermisches Regulierungsfluid (6), wobei dieses Zufuhrelement (5) und dieses Abfuhrelement (6) mit dem internen Hohlraum (3) in Verbindung stehen, wobei das Zufuhrelement (5) und das Abfuhrelement (6) jeweils auf einer der Außenflächen (220) der Seitenwände (22) des Kastens (2) hervorstehen, und dadurch, dass das Zufuhrelement (5) und das Abfuhrelement (6) auf den Seitenwänden (22) in unterschiedlichen Abständen von der Bodenwand (21) angeordnet sind, **dadurch gekennzeichnet, dass** das Zufuhrelement (5) eine Leitung (50) umfasst, die sich hauptsächlich entlang einer Längsrichtung erstreckt, wobei diese Leitung (50) in Längsrichtung durch zwei Wände (51, 52) begrenzt ist, von denen eine erste Wand (51) in der Nähe eines ersten Längsendes des Kastens (200) einen Stutzen (56) trägt, wobei die Leitung (50) einen Querschnitt in einer Ebene senkrecht zur Längsrichtung aufweist, der sich mit zunehmendem Abstand von der ersten Wand (51) verringert, und dadurch, dass das Abfuhrelement (6) eine Leitung (60) umfasst, die sich hauptsächlich entlang einer Längsrichtung erstreckt, wobei diese Leitung (60) in Längsrichtung durch zwei Wände (61, 62) begrenzt ist, von denen eine erste Wand (61) in der Nähe eines zweiten Längsendes des Kastens (201), das dem ersten Längsende des Kastens (200) gegenüberliegt, einen Stutzen (66) trägt, wobei die Leitung (60) einen Querschnitt in einer Ebene
senkrecht zur Längsrichtung aufweist, der sich mit zunehmendem Abstand von der ersten Wand (61) vergrößert.

2. Thermische Regulierungsvorrichtung (1) nach dem vorhergehenden Anspruch, bei der das Zufuhrelement (5) auf der Außenfläche (220) einer Seitenwand (22) des Kastens (2) hervorsteht und das Abfuhrelement (6) auf der Außenfläche (220) einer gegenüberliegenden Seitenwand (22) des Kastens (2) hervorsteht.

3. Thermische Regulierungsvorrichtung (1) nach einem der vorhergehenden Ansprüche, bei der das Zufuhrelement (5) von der Bodenwand (22) durch einen größeren Abstand getrennt ist als der Abstand, der das Abfuhrelement (6) von der Bodenwand (22) trennt.

4. Thermische Regulierungsvorrichtung (1) nach einem der vorhergehenden Ansprüche, bei der die Leitung (50, 60) einen Vorsprung bildet, der in einer Ebene senkrecht zur Längsrichtung eine U-Form aufweist, die zum internen Hohlraum (3) des Kastens (2) hin offen ist.

5. Thermische Regulierungsvorrichtung (1) nach einem der Ansprüche 1 bis 4, bei der der Kasten (2) eine Basis und einen Deckel (23) umfasst, wobei die Basis aus der Bodenwand (21) und den Seitenwänden (22) besteht, wobei diese Basis aus einem ersten Element gebildet ist, das die Bodenwand (21) und zwei gegenüberliegende Seitenwände (22) umfasst, wobei die beiden anderen Seitenwände (22) angebracht und am ersten Element befestigt sind.

6. Elektronisches System, umfassend eine thermische Regulierungsvorrichtung (1) nach einem der vorhergehenden Ansprüche und elektrische und/oder elektronische Komponenten (4), die im Kasten (2) der thermischen Regulierungsvorrichtung (1) untergebracht sind, wobei die elektrischen und/oder elektronischen Komponenten (4) von mindestens einer elektrischen und/oder elektronischen Komponente (4) durch ein Trennelement (8) getrennt sind.

7. Elektronisches System nach Anspruch 6, umfassend ein Dichtungselement (9), das konfiguriert ist, um zwischen den elektrischen und/oder elektronischen Komponenten (4) und den Wänden (22) angeordnet zu werden.

## Claims

1. Thermal regulation device (1) for electronic system comprising a housing (2) configured to accommodate electrical and/or electronic components (4) of said electronic system, this housing (2) having a bottom wall (21) and lateral walls (22) opposed in pairs defining an internal compartment (3) suitable for receiving the electrical and/or electronic components (4), external faces (220) of these lateral walls (22) being defined as those opposite to the internal compartment (3), this housing (2) comprising:
- at least one thermal regulation fluid supply element (5);
- at least one thermal regulation fluid evacuation element (6), this supply element (5) and this evacuation element (6) communicating with the internal compartment (3), the supply element (5) and the evacuation element (6) respectively protruding on one of the external faces (220) of the lateral walls (22) of the housing (2), and wherein the supply element (5) and the evacuation element (6) are arranged on the lateral walls (22) at different distances from the bottom wall (21), **characterized in that** the supply element (5) comprises a conduit (50) extending mainly along a longitudinal direction, this conduit (50) being longitudinally delimited by two walls (51, 52) among which a first wall (51), in the vicinity of a first longitudinal end of the housing (200), carries a nozzle (56), the conduit (50) having a section, in a plane perpendicular to the longitudinal direction, that reduces as it moves away from the first wall (51), and **in that** the evacuation element (6) comprises a conduit (60) extending mainly along a longitudinal direction, this conduit (60) being longitudinally delimited by two walls (61, 62) among which a first wall (61), in the vicinity of a second longitudinal end of the housing (201) opposite to the first longitudinal end of the housing (200), carries a nozzle (66), the conduit (60) having a section, in a plane
perpendicular to the longitudinal direction, that widens as it moves away from the first wall (61).

2. Thermal regulation device (1) according to the preceding claim, wherein the supply element (5) protrudes on the external face (220) of a lateral wall (22) of the housing (2) and the evacuation element (6) protrudes on the external face (220) of an opposite lateral wall (22) of the housing (2).

3. Thermal regulation device (1) according to any one of the preceding claims, wherein the supply element (5) is separated from the bottom wall (22) by a greater distance than the distance separating the evacuation element (6) from the bottom wall (22).

4. Thermal regulation device (1) according to any one of the preceding claims, wherein the conduit (50, 60) forms a protrusion which has, in a plane perpendicular to the longitudinal direction, a U-shape open to the internal compartment (3) of the housing (2).

5. Thermal regulation device (1) according to any one of claims 1 to 4, wherein the housing (2) comprises a base and a cover (23), the base being constituted by the bottom wall (21) and the lateral walls (22), this base being formed of a first element comprising the bottom wall (21) and two opposite lateral walls (22), the two other lateral walls (22) being added and fixed to the first element.

6. Electronic system comprising a thermal regulation device (1) according to any one of the preceding claims and electrical and/or electronic components (4) housed in the housing (2) of said thermal regulation device (1), wherein the electrical and/or electronic components (4) are separated from at least one electrical and/or electronic component (4) by a separation member (8).

7. Electronic system according to claim 6, comprising a sealing element (9) configured to be arranged between the electrical and/or electronic components (4) and the walls (22).
